# EUROPEAN PATENT APPLICATION

(11) **EP 4 203 001 A1**
(43) Date of publication of application: **28.06.2023**
(21) Application number: 22205718.4
(22) Date of filing: 07.11.2022
(51) Int. Cl.: H01L 21/8258, H01L 27/085, H01L 27/092, H01L 29/778

(54) **INTEGRATED GROUP III-NITRIDE AND SILICON TRANSISTORS ON THE SAME DIE**

(30) Priority: 22.12.2021 US 202117558667
(71) Applicant: Intel Corporation, Santa Clara, CA 95054 (US)
(72) Inventor: RADOSAVLJEVIC, Marko, Portland, 97229 (US); THEN, Han, Portland, 97229 (US); DASGUPTA, Sansaptak, Portland, 97229 (US); FISCHER, Paul, Portland, 97229 (US); JUN, Kimin, Portland, 97229 (US); MUELLER, Brennen, Portland, 97229 (US)
(74) Representative: Goddar, Heinz J.

(57) **Abstract**

In one embodiment, an integrated circuit includes a silicon substrate, a gallium nitride (GaN) layer above the silicon substrate, a bonding layer above the GaN layer, and a silicon layer above the bonding layer. Further, the integrated circuit includes a first transistor on the GaN layer and a second transistor on the silicon layer.

## Description

### BACKGROUND

Group III-N semiconductors, such as gallium nitride (GaN), have several advantages over silicon (Si), particularly for high-power electronics and radio frequency (RF) applications, such as 5G radio. In particular, GaN has a direct and wide bandgap, high breakdown field, thermal stability (e.g., high melting point), and high electron mobility due to its ability to form a high-mobility two-dimensional electron gas (2DEG) at a heterointerface with another III-V semiconductor. As a result, GaN-based NMOS transistors are well suited for power-hungry, highfrequency applications with high operating temperatures (e.g., voltage regulators, RF front-end components such as power amplifiers, low noise amplifiers, RF switches). However, GaN-based PMOS transistors remain problematic due to low active p-doping and low hole mobility. Accordingly, some applications leverage GaN NMOS in conjunction with Si PMOS. For example, in some cases, GaN NMOS and Si PMOS transistors may be fabricated on separate dies and then heterogeneously packaged together. However, this approach not only suffers from higher costs and increased chip size, but it is also more susceptible to parasitics, particularly for applications with numerous interconnections between the respective GaN and Si devices.

### BRIEF DESCRIPTION OF THE DRAWINGS

**FIG. 1** illustrates an example embodiment of an integrated circuit with horizontally-integrated group III-nitrogen (III-N) and silicon (Si) transistors on the same die.
**FIGS. 2A-B** illustrate an example embodiment of an integrated circuit with horizontally-integrated III-N and Si transistors in perpendicular orientations on the same die.
**FIGS. 3A-C** illustrate an example fabrication process for horizontal integration of III-N and Si transistors on the same die.
**FIG. 4** illustrates a flowchart for fabricating an integrated circuit with horizontally-integrated III-N and Si transistors on the same die.
**FIGS. 5A-C** illustrate an example embodiment of an integrated circuit with vertically-integrated III-N and Si transistors on the same die.
**FIG. 6** illustrates for fabricating an integrated circuit with vertically-integrated III-N and Si transistors on the same die.
**FIG. 7** illustrates an example embodiment of a radio frequency transmitter.
**FIG. 8** illustrates an example embodiment of a radio frequency receiver.
**FIG. 9** illustrates a block diagram of an example electrical device that may include one or more embodiments of the disclosure.
**FIG. 10** is a top view of a wafer and dies that may be included in a microelectronic assembly, in accordance with any of the embodiments disclosed herein.
**FIG. 11** is a cross-sectional side view of an integrated circuit device that may be included in a microelectronic assembly, in accordance with any of the embodiments disclosed herein.
**FIG. 12** is a cross-sectional side view of an integrated circuit device assembly that may include a microelectronic assembly, in accordance with any of the embodiments disclosed herein.

### DETAILED DESCRIPTION

Group III-N semiconductors, such as gallium nitride (GaN), have several advantages over silicon (Si), particularly for high-power electronics and radio frequency (RF) applications. In particular, GaN has a direct and wide bandgap, high breakdown field, thermal stability (e.g., high melting point), and high electron mobility due to its ability to form a high-mobility two-dimensional electron gas (2DEG) at a heterointerface with another III-V semiconductor. As a result, GaN-based semiconductor devices are particularly beneficial for power-hungry, highfrequency applications with high operating temperatures, such as 5G radio. As an example, GaN NMOS transistors enable compact integration of energy-efficient voltage regulators and RF front-end components, such as power amplifiers, low noise amplifiers, and RF switches, in a system-on-chip (SoC).

However, high-performance, low-leakage PMOS transistors are also needed for full integration of energy-efficient and compact applications that demand CMOS digital signal processing, logic computation and control, memory functions, and analog components, such as current mirrors and driver circuitries. GaN-based PMOS transistors, however, remain very challenging due to low active p-doping and low hole mobility. Si PMOS transistors, on the other hand, are a proven complementary P-channel technology. As a result, some applications require the use of both GaN NMOS technology and Si PMOS technology.

As an example, III-N (e.g., GaN) transistor technology is one of the leading candidates for 5G applications due to its high speed and ability to withstand high power. One key hurdle for 5G RF technology, however, is the challenge of implementing RF circuitry and control logic on the same die. For example, RF functions are better suited for implementation using GaN NMOS technology due to the benefits described above, but control functions-which require CMOS technology-are typically implemented using Si CMOS due to the lack of viable GaN PMOS solutions. As a result, control logic and RF circuitry are typically implemented on separate dies and then heterogeneously packaged together, which not only increases costs and chip size, but also renders them more susceptible to parasitics (e.g., parasitic capacitance/inductance), particularly for applications where numerous connections are required between the control logic and RF circuitry.

Accordingly, this disclosure presents various embodiments for integrating GaN NMOS transistors and Si NMOS/PMOS transistors on the same die/wafer. In particular, the described embodiments leverage fabrication processes for III-N devices (e.g., GaN NMOS transistors) in conjunction with a layer transfer of crystalline Si over a bonding layer, which enables Si NMOS/PMOS devices to be fabricated on the same die. Moreover, in various embodiments described below, the III-N and Si devices can be integrated horizontally (e.g., laterally on the same plane) or vertically (e.g., above/below each other).

These embodiments provide numerous advantages, including lower fabrication costs, higher transistor density and smaller chip size, and reduced parasitics (e.g., particularly for applications where numerous connections are required between the Si and GaN transistors, such as RF signal processing and control logic), among other examples. In addition, these embodiments also increase the versatility of III-N devices, thus increasing the number of possible applications. In particular, same-die integration of GaN NMOS and Si PMOS enables full integration of compact, energy-efficient power delivery and RF solutions with CMOS digital signal processing, logic computation and control, memory functions, and analog circuitries for the next generation of power delivery, RF (5G and beyond), and SoC applications. As one example, the described embodiments enable RF signal processing (e.g., the RF front end) and control logic to be integrated on a single die using the optimal transistor technologies for each type of functionality.

### Horizontal Integration of III-N and Silicon Transistors

In some embodiments of this disclosure, III-N (e.g., GaN) and Si transistors are integrated horizontally, or side by side, on the same die. In particular, both types of transistors are fabricated side-by-side on a base stack of III-N layers grown on a substrate. For example, the substrate may be a Si(111) substrate, which has a lattice orientation that is well-suited for epitaxial growth of III-N materials (e.g., GaN). Moreover, the base III-N stack formed on the substrate includes various layers that are incorporated into the resulting III-N transistors, but for the Si transistors, the III-N stack simply serves as a substrate.

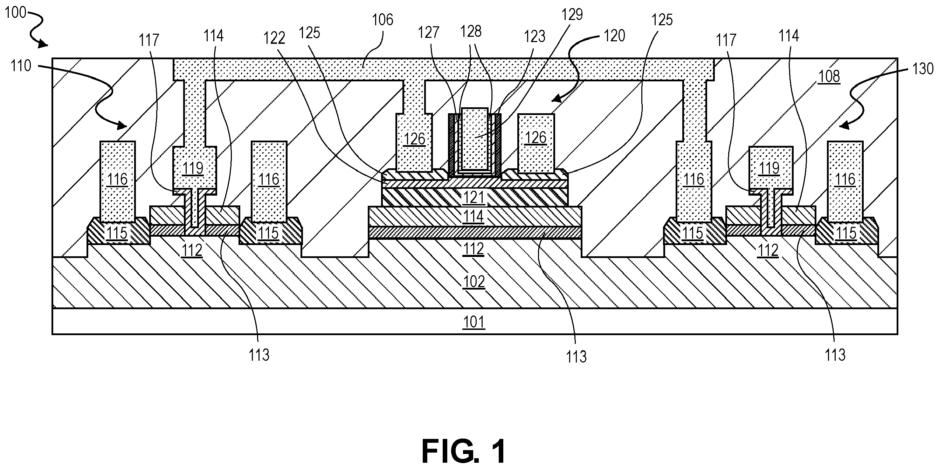

For example, the III-N transistors are formed directly on the III-N stack, with certain layers of the III-N stack serving as the channel and polarization layers for those transistors. The Si transistors are formed above the III-N stack-but lateral to the III-N transistors-on a transferred Si layer, which is bonded to the III-N stack via a bonding layer. For example, the bonding layer may be formed by depositing a bonding material (e.g., an oxide, such as silicon oxide (SiO)) on the III-N stack and then smoothing out its surface until pristinely flat (e.g., via polishing/etching), thus enabling the subsequently transferred Si layer to bond with, or stick to, the underlying III-N stack. By using the layer transfer scheme instead of epitaxial growth, the transferred Si layer can have any desired lattice orientation, such as crystalline Si(100), which is well-suited for epitaxial growth of the Si transistors. In this manner, Si NMOS and/or PMOS transistors can then be formed on the transferred Si layer. Example embodiments using this approach are described further in connection with FIGS. 1-4 below.

**FIG.** 1 illustrates an example embodiment of an integrated circuit 100 with horizontally-integrated group III-nitrogen (III-N) and silicon (Si) transistors on the same die. In particular, integrated circuit 100 includes multiple III-N transistors 110, 130 and a Si transistor 120, which are integrated horizontally on the same underlying substrate 101 and further coupled via an interconnect 106.

In the illustrated embodiment, for example, the III-N transistors 110, 130 and Si transistor 120 are fabricated side-by-side on a base stack of layers (e.g., layers 102, 112-114) grown on the substrate 101. The base stack includes various layers that are incorporated into the resulting III-N transistors 110, 130 (e.g., layers 112-114), but for the Si transistor 120, the base stack simply serves as a substrate, as described further below.

In some embodiments, the substrate 101 contains a material with a crystal lattice orientation suitable for epitaxial growth of III-N materials (e.g., GaN), such as a Si(111) substrate. Moreover, the base stack (102, 112-114) grown on the substrate 101 includes multiple layers of III-N and other materials, including a base layer or buffer 102, a channel layer 112, a polarization layer 113, and an insulator layer 114.

The buffer layer 102 is formed on the substrate 101 and provides various structural benefits for the overlying layers. In some embodiments, the buffer layer 102 includes one or more layers of III-N materials, such as aluminum gallium nitride (AlGaN), gallium nitride (GaN), and so forth.

The III-N channel layer 112 is formed above the buffer layer 102, or otherwise as the top portion of the buffer layer 102, and further serves as the transistor channel for the III-N transistors 110, 130. In some embodiments, the III-N channel layer 112 includes one or more III-N materials, such as gallium nitride (GaN).

The polarization layer 113 is formed on or above the III-N channel layer 112 and may include one or more III-N materials, such as aluminum gallium nitride (AlGaN), aluminum indium nitride (AlInN), aluminum gallium indium nitride (AlGaInN), and so forth. The function of the polarization layer 113 is to induce the formation of a high-mobility two-dimensional electron gas (2DEG) at the heterointerface of the polarization layer 113 and the channel layer 112. For example, when an AlGaN polarization layer 113 is deposited on a GaN channel layer 112, a two-dimensional electron gas (2DEG) forms at or near the interface of those layers, which increases electron mobility in the transistor channel 112.

The insulator layer 114 is formed on or above the polarization layer 113 and may include one or more dielectric materials, such as silicon dioxide (SiO₂) and/or other oxides, silicon nitride (SiN), and so forth. The insulator layer 114 may provide protection from contamination and/or from diffusion current caused by the diffusion of charge carriers.

Source/drain (S/D) regions 115 for each III-N transistor 110, 130 are formed on opposite sides of the III-N channel 112 such that the channel 112 extends between them. In some embodiments, the S/D regions 115 include one or more III-N materials, such as indium gallium nitride (e.g., N+ InₓGa₁₋ₓN, where x is between 0 and 0.3 and the dopant is Si).

Source/drain (S/D) contacts 116 are formed on or above above-and in contact with-the respective S/D regions 115. In some embodiments, the S/D contacts 116 include one or more metal materials, such as tungsten, nickel, aluminum, copper, and/or cobalt, among other examples.

A gate 119 is formed above the channel 112 for each III-N transistor 110, 130, along with a gate dielectric 117 at least partially surrounding the gate 119. In some embodiments, the gate 119 is formed as a T-gate, which has a shape that resembles the letter "T", with a wider upper portion and narrower lower portion. Moreover, the gate dielectric 117 may surround at least the lower portion of the T-gate 119. Further, in some embodiments, the lower portion of the T-gate 119, surrounded by the gate dielectric 117, extends down through the insulator layer 114 and into the polarization layer 113. In some embodiments, the gate 119 includes one or more metal materials, such as titanium nitride (TiN) or nickel. Further, in some embodiments, the gate dielectric 117 includes one or more oxides and/or other dielectric materials, such as hafnium oxide (HfO), zirconium oxide (ZrO), aluminum oxide (AlO), and so forth.

In this manner, the III-N transistors 110, 130 are formed directly on the base stack of layers, such that the III-N channel layer 112, polarization layer 113, and insulator layer 114 are incorporated into, and become part of, the respective III-N transistors 110, 130. In the illustrated embodiment, for example, each III-N transistor 110, 130 includes a channel 112, a polarization layer 113, an insulator layer 114, S/D regions 115, S/D contacts 116, a gate dielectric 117, and a gate 119.

The Si transistor 120 is formed above the base stack (e.g., layers 102, 112-114)-lateral to the III-N transistors 110, 130-on a transferred Si layer 122, which is bonded to the base stack via a bonding layer 121. In some embodiments, the bonding layer 121 is formed by depositing one or more bonding materials on the base stack, such as a bonding oxide (e.g., silicon oxide (SiO)), and then smoothing out the surface until pristinely flat (e.g., via polishing/etching). In this manner, when the Si layer 122 is subsequently transferred on top of the bonding layer 121, the bonding layer 121 enables the Si layer 122 to bond with, or stick to, the underlying base stack.

By using the layer transfer scheme instead of epitaxial growth, the transferred Si layer 122 can have any suitable crystal lattice orientation, such as crystalline Si(100). In some embodiments, for example, the transferred Si layer 122 is a Si(100) donor wafer, which has a crystal lattice orientation well-suited for epitaxial growth of the Si transistor 120 layers. In this manner, the Si transistor 120 (e.g., NMOS or PMOS) can then be formed on the transferred Si layer 122.

In particular, the transferred Si wafer 122 is used to form the channel 122 of the Si transistor 120. For example, because the transferred Si wafer 122 may be relatively thick, it may be thinned down to the appropriate thickness of the Si channel layer 122 using various techniques, such as polishing, grinding, cleaving, and so forth.

Source/drain (S/D) regions 125 for the Si transistor 120 are then formed on opposite sides of the Si channel 122 such that the channel 122 extends between them. In some embodiments, the S/D regions 115 include one or more group IV semiconductor materials, such as Si with a p-type dopant (e.g., boron) for PMOS and/or an n-type dopant (e.g., phosphorous, arsenic) for NMOS.

Source/drain (S/D) contacts 126 are formed on or above above-and in contact with-the respective S/D regions 125. In some embodiments, the S/D contacts 126 include one or more metal materials and/or other electrically conductive materials, such as tungsten, nickel, aluminum, copper, and/or cobalt, among other examples.

A gate stack is formed above the channel 122 of the Si transistor 120, which includes gate spacers 123, a gate dielectric 127, a work function metal 128, and a fill metal 129. The gate spacers 123 may include any suitable spacer material, such as any suitable electrical insulator, dielectric, oxide (e.g., silicon oxide), and/or nitride (e.g., silicon nitride) material, among other examples. The gate dielectric 127 may include any suitable oxide (e.g., hafnium oxide (HfO), silicon dioxide (SiO₂)), high-k dielectric material, and/or any other suitable dielectric material. The work function metal 128 and/or fill metal 129 may include one or more metal and/or other electrically conductive materials, such as tungsten (W), titanium (Ti), tantalum (Ta), copper (Cu), aluminum (Al), titanium nitride (TiN), and/or tantalum nitride (TaN), among other examples.

Further, the source, drain, and/or gate contacts of the respective transistors 110, 120, 130 are interconnected via an interconnect 106, which may include one or more metals and/or other electrically conductive materials.

The remaining area or volume of the integrated circuit is filled with an inter-layer dielectric (ILD) 108, such as silicon dioxide (SiO₂) and/or any other suitable dielectric material.

In various embodiments, certain layers of integrated circuit 100 may be omitted, added, or rearranged. Moreover, certain layers may be formed using materials other than those described above, including any of the materials described throughout this disclosure. Further, in actual embodiments, integrated circuit 100 may include any number of III-N and/or Si transistors.

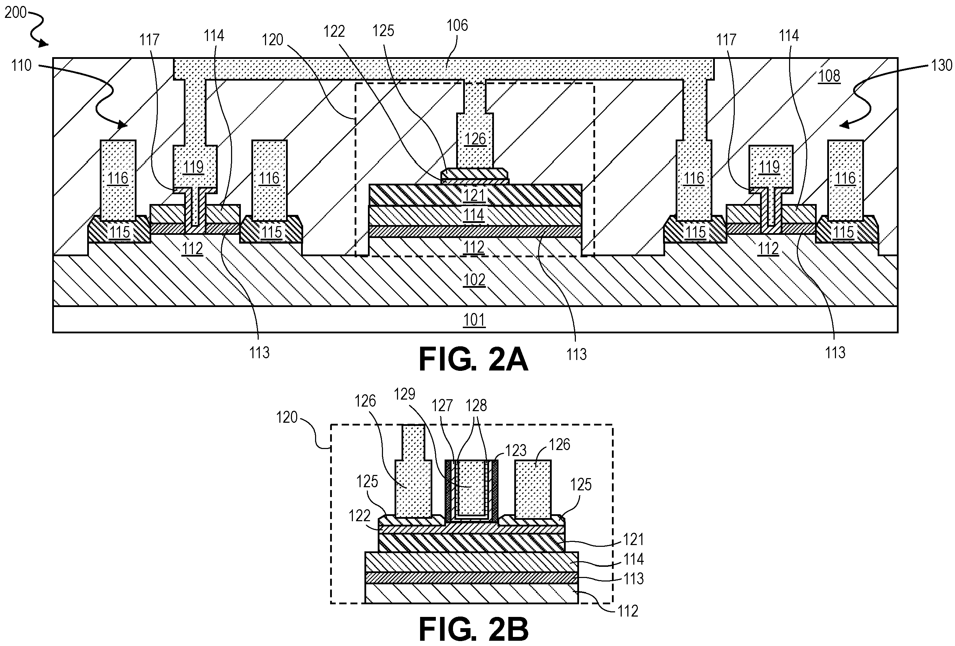

FIGS. 2A-B illustrate an example embodiment of an integrated circuit 200 with horizontally-integrated group III-nitrogen (III-N) and silicon (Si) transistors in perpendicular orientations on the same die. In the illustrated example, integrated circuit 200 is an alternative embodiment of integrated circuit 100, where the orientation of the Si transistor 120 is perpendicular to that of the III-N transistors 110, 130. FIG. 2A shows a cross-section of integrated circuit 200 in its entirety (from the same perspective shown for integrated circuit 100 of FIG. 1), while FIG. 2B shows a cross-section of the Si transistor 120 with 90 degrees of rotation relative to FIG. 2A.

In the illustrated embodiment, the orientation of the Si transistor 120 is rotated 90 degrees relative to the III-N transistors 110, 130. Thus, from the perspective shown in FIG. 2A, only one of the source/drain regions 126 of the Si transistor 120 is visible, while the other source/drain region 126 and the gate 129 are hidden behind it. In FIG. 2B, however, the perspective of the Si transistor 120 is rotated 90 degrees, which reveals that it has the same design as the embodiment in FIG. 1 (e.g., channel 122, source/drain regions 126, gate 129, etc.), but simply a different orientation.

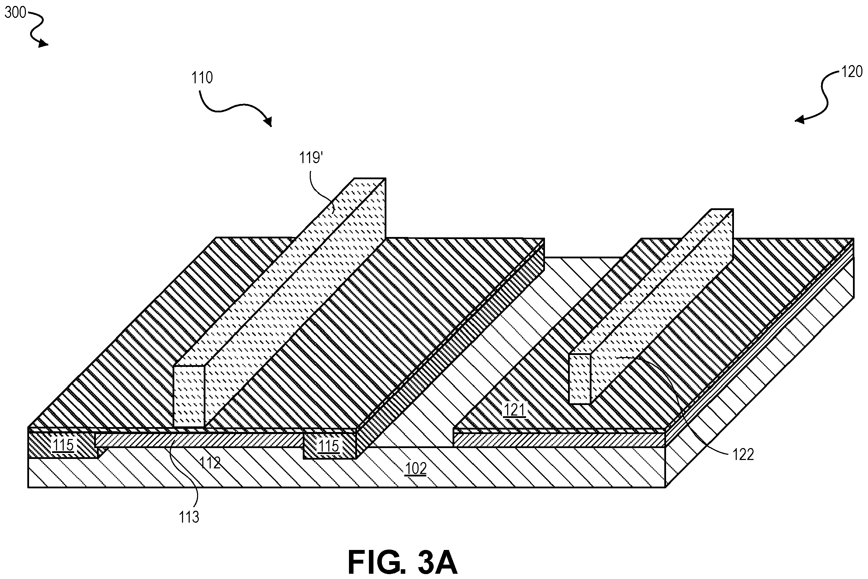

This design is motivated by a streamlined fabrication process where the III-N and Si transistors 110-130 are fabricated simultaneously rather than sequentially, as described further below in connection with FIGS. 3A-C.

FIGS. 3A-C illustrate an example fabrication process for horizontal integration of group III-nitrogen (III-N) and silicon (Si) transistors on the same die. In some embodiments, for example, the process depicted in FIGS. 3A-C can be used to fabricate the integrated circuit 200 of FIGS. 2A-B. In the illustrated example, however, only certain steps of the fabrication process are depicted, and the resulting structures are simplified, for ease of illustration and understanding.

In the illustrated example, an integrated circuit 300 is fabricated with one III-N transistor 110 and one Si transistor 120, which are integrated horizontally and oriented perpendicular to each other, as described further below.

In FIG. 3A, the integrated circuit 300 is shown at an intermediate stage where the III-N transistor 110 and Si transistor 120 have been partially fabricated. In particular, the buffer layer 102, channel 112, polarization layer 113, and source/drain regions 115 have been formed for the III-N transistor 110. In addition, the bonding layer 121 layer has been formed on the base stack, the Si(100) donor wafer 122 has been transferred on the bonding layer 121, and the Si(100) donor wafer 122 has been formed into (i) a Si channel 122 for the Si transistor 120 and (ii) a dummy gate 119' (made of Si) for the III-N transistor 110. In this manner, the channel 122 for the Si transistor 120 and the dummy gate 119' for the III-N transistor 110 are formed simultaneously from the same layer and thus are coplanar. In addition, as shown in the figure, the Si channel 122 is formed perpendicular to the III-N channel 112.

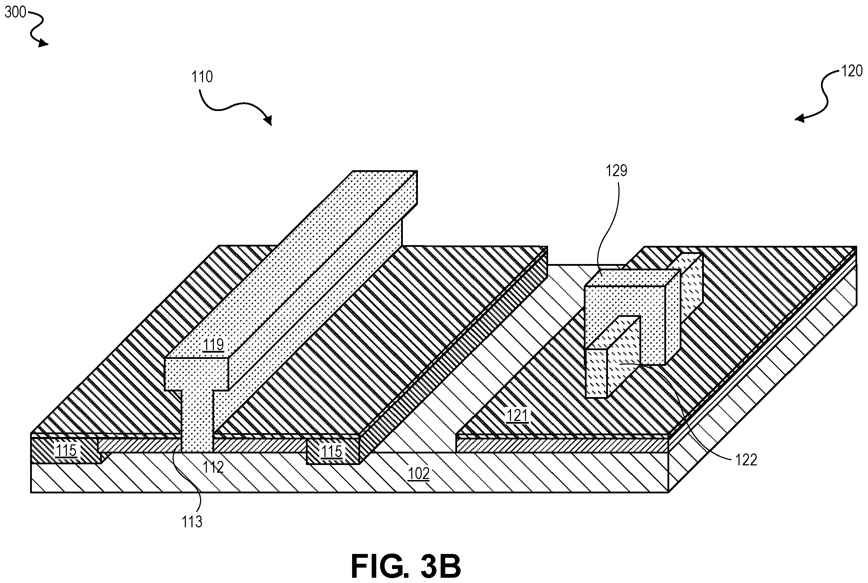

In FIG. 3B, the dummy gate 119' made of Si is replaced with metal and formed into a T-gate 119 for the III-N transistor 110. InN addition, a gate 129 is also formed for the Si transistor 120.

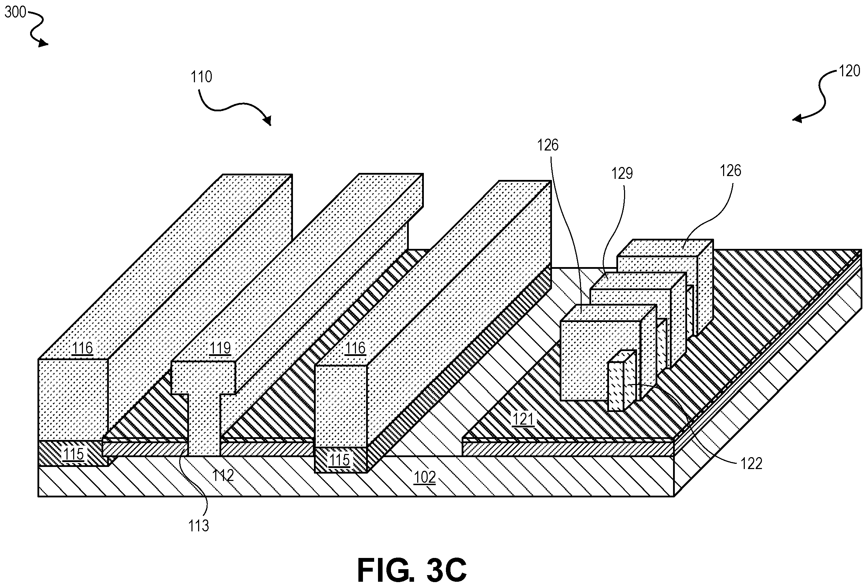

In FIG. 3C, the source/drain contacts 116 for the III-N transistor 110, and the source/drain contacts 126 for the Si transistor 120, are formed, completing the respective transistors 110, 120.

In this manner, the III-N transistor 110 and the Si transistor 120 are integrated horizontally (e.g., side by side on the same horizontal plane) on the same die, with orientations that are perpendicular to each other, as described above in connection with FIGS. 2A-B.

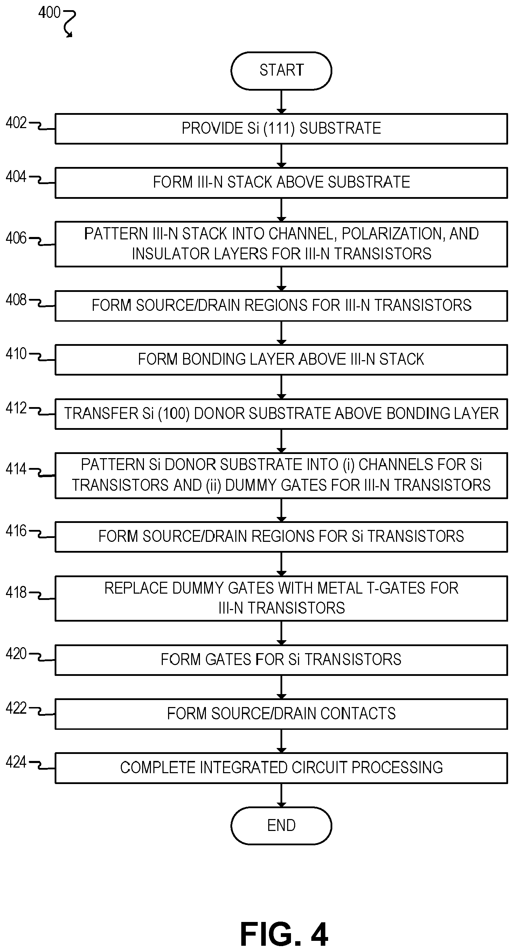

**FIG. 4** illustrates a flowchart 400 for fabricating an integrated circuit with horizontally-integrated group III-nitrogen (III-N) and silicon (Si) transistors on the same die. In some embodiments, for example, flowchart 400 may be used to fabricate the integrated circuits 100, 200, 300 of FIGS. 1, 2A-B, and 3A-C. It will be appreciated in light of the present disclosure, however, that flowchart 400 is only one example methodology for arriving at the example integrated circuit structures shown and described throughout this disclosure.

The steps of flowchart 400 may be performed using any suitable semiconductor fabrication techniques. For example, film deposition-such as depositing layers, filling portions of layers (e.g., removed portions), and filling via openings-may be performed using any suitable deposition techniques, including, for example, chemical vapor deposition (CVD), metalorganic chemical vapor deposition (MOCVD), molecular beam epitaxy (MBE) atomic layer deposition (ALD), and/or physical vapor deposition (PVD). Moreover, patterning and removal-such as interconnect patterning, forming via openings, and shaping-may be performed using any suitable techniques, such as lithography-based patterning/masking and/or etching.

The flowchart begins at block 402 by providing a substrate, such as a silicon (Si) (111) substrate.

The flowchart then proceeds to block 404 to form a base stack of layers for the III-N transistors above the substrate. In particular, the base stack may include buffer, channel, and polarization layers, each of which may include one or more of the III-N materials described throughout this disclosure. For example, the III-N materials may include aluminum (Al), gallium (Ga), indium (In), and/or nitrogen (N), such as gallium nitride (GaN), indium gallium nitride (InGaN), aluminum gallium nitride (AlGaN), aluminum indium nitride (AlInN), and/or aluminum gallium indium nitride (AlGaInN), among other examples.

The base stack may also include an insulator layer, which may include any of the dielectric or insulating materials described through this disclosure. For example, the insulator layer my include one or more materials that include oxygen, silicon, and/or nitrogen, such as silicon dioxide (SiO₂), silicon nitride (SiN), and so forth.

The flowchart then proceeds to block 406 to pattern the base stack into the channel, polarization, and insulator layers for the respective III-N transistors.

The flowchart then proceeds to block 408 to form the source/drain regions for the III-N transistors. The source/drain regions for the III-N transistors may include one or more of the III-N materials described throughout this disclosure. For example, the source/drain regions may be formed from one or more materials that include aluminum (Al), gallium (Ga), indium (In), and/or nitrogen (N), such as gallium nitride (GaN), indium gallium nitride (InGaN), aluminum gallium nitride (AlGaN), aluminum indium nitride (AlInN), and/or aluminum gallium indium nitride (AlGaInN), among other examples.

The flowchart then proceeds to block 410 to form a bonding layer above the III-N stack. The bonding layer may include one or more materials that include oxygen and/or silicon, such as silicon oxide (SiO), among other examples. The bonding layer may then be polished/etched until its surface its flat.

The flowchart then proceeds to block 412 to transfer a donor substrate for the Si transistors on/above the bonding layer, such as a Si(100) donor substrate.

The flowchart then proceeds to block 414 to pattern the Si(100) donor substrate into (i) channels for the Si transistors and (ii) dummy gates for the III-N transistors.

The flowchart then proceeds to block 416 to form source/drain regions for the Si transistors. The source/drain regions for the Si transistors may include one or more of the group IV materials described throughout this disclosure. For example, the source/drain regions may be formed from one or more materials that include silicon, boron, phosphorous, and/or arsenic, such as silicon with a p-type dopant (e.g., boron) and/or silicon with an n-type dopant (e.g., phosphorous, arsenic), among other examples.

The flowchart then proceeds to block 418 to replace the dummy gates with metal T-gates for the III-N transistors. The T-gates may include one or more metals and/or other electrically conductive materials described throughout this disclosure, such as materials that include tungsten (W), titanium (Ti), tantalum (Ta), copper (Cu), aluminum (Al), and/or nitrogen, including titanium nitride (TiN), and/or tantalum nitride (TaN), among other examples.

The flowchart then proceeds to block 420 to form gates for the Si transistors. The gates for the Si transistors may include one or more metals and/or other electrically conductive materials described throughout this disclosure, such as materials that include tungsten (W), titanium (Ti), tantalum (Ta), copper (Cu), aluminum (Al), and/or nitrogen, including titanium nitride (TiN), and/or tantalum nitride (TaN), among other examples.

The flowchart then proceeds to block 422 to form source/drain contacts for the III-N and Si transistors. The source/drain contacts may include one or more metals and/or other electrically conductive materials described throughout this disclosure, such as materials that include tungsten, nickel, aluminum, copper, and/or cobalt, among other examples.

The flowchart then proceeds to block 424 to complete the integrated circuit by performing any remaining backend processing.

At this point, the flowchart may be complete. In some embodiments, however, the flowchart may restart and/or certain blocks may be repeated. For example, in some embodiments, the flowchart may restart at block 402 to continue fabricating integrated III-N and Si transistors on the same die.

### Vertical Integration of III-N and Silicon Transistors

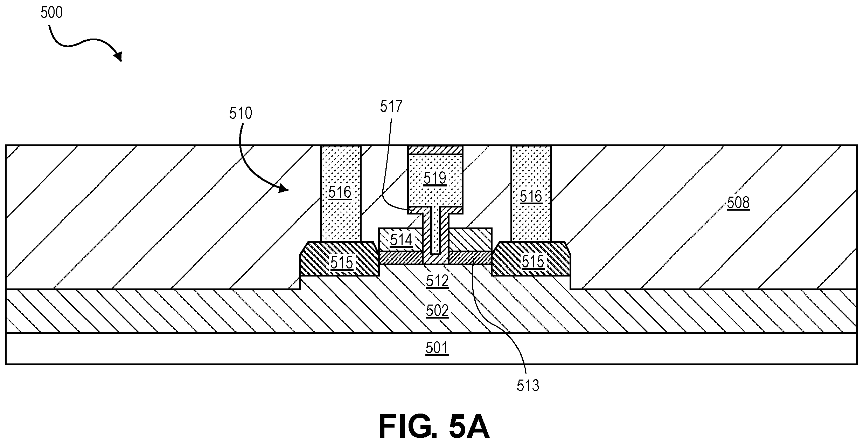

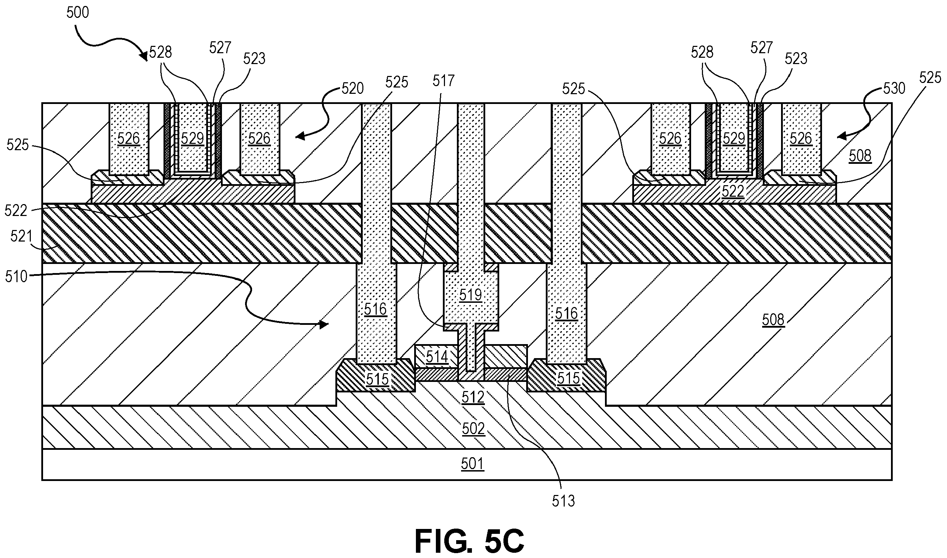

**FIGS. 5A-C** illustrate an example embodiment of an integrated circuit 500 with vertically-integrated group III-nitride (III-N) and silicon (Si) transistors on the same die. In particular, the completed integrated circuit 500 (shown in FIG. 5C) includes a III-N transistor 510 and multiple Si transistors 520, 530, which are integrated vertically on the same underlying substrate 501. In some embodiments, the respective layers, structures, and materials in FIGS. 5A-C may be similar to those having similar reference numerals in other figures of this disclosure.

In the illustrated embodiment, for example, the III-N transistor 510 is fabricated below the Si transistors 520, 530. In particular, III-N fabrication processes are used to fabricate the III-N transistor 510 (e.g., GaN NMOS) on a Si(111) base substrate 501, followed by a fusion-bonded layer transfer of a Si(100) donor substrate 522 above the finished III-N transistor 510, and then Si fabrication processes-augmented with thermal processing suitable for the full stack-are used to fabricate the Si transistors 520, 530 (e.g., Si PMOS, NMOS) on the transferred donor substrate 522. In this manner, the Si transistors 520, 530 are integrated on top of the III-N transistor 510 on the same die 501.

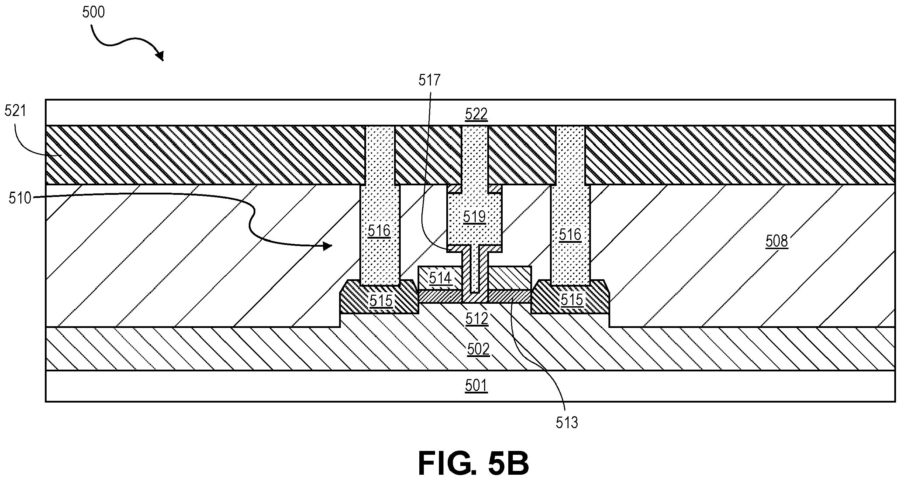

In the illustrated example, FIG. 5A shows the finished III-N transistor 510 on the Si(111) base substrate 501, FIG. 5B shows the transferred, fusion-bonded Si(100) donor substrate 522 above the finished III-N transistor 510, and FIG. 5C shows the finished Si transistors 520, 530 fabricated in the transferred Si(100) layer 522 above the III-N transistor 510.

In FIG. 5A, for example, a base stack of layers for the III-N transistor 510 is formed on the Si(111) substrate 501, including a buffer layer 502 (e.g., AlGaN), a channel layer 512 (e.g., GaN), a polarization layer 513 (e.g., AlGaN, AlInN, AlGaInN), and an insulator layer 514 (e.g., an oxide, SiN). In addition, source/drain regions 515, source/drain contacts 516, a gate dielectric 517, and a T-gate 519 for the III-N transistor 510 are formed on the stack. The remaining area is filled with an inter-layer dielectric (ILD) 508.

In FIG. 5B, a Si(100) donor substrate 522 is transferred and fusion-bonded above the finished III-N transistor 510 via a bonding layer 521. In some embodiments, for example, the bonding layer 521 is formed by depositing one or more bonding materials above the finished III-N transistor 510 stack, such as a bonding oxide (e.g., silicon oxide (SiO)), and then smoothing out the surface until pristinely flat (e.g., via polishing/etching). In this manner, when the Si(100) donor wafer 522 is subsequently transferred on top of the bonding layer 521, the bonding layer 521 enables the Si donor wafer 522 to bond with, or stick to, the underlying III-N transistor 510 stack.

By using the layer transfer scheme instead of epitaxial growth, the transferred Si layer 522 can have any desired lattice orientation, such as crystalline Si(100), which is well-suited for epitaxial growth of the Si transistors 520, 530. In this manner, Si NMOS and/or PMOS transistors 520, 530 can then be formed on the transferred Si layer 522.

For example, in FIG. 5C, the Si transistors 520, 530 are fabricated on the transferred Si(100) layer 522 above the III-N transistor 510 stack. In the illustrated example, each Si transistor 520, 530 includes a channel 522 (e.g., formed from the transferred Si(100) wafer 522), source/drain regions 525, source/drain contacts 526, and a gate stack (e.g., gate spacers 523, gate dielectric 527, work function metal 528, and fill metal 529). In various embodiments, the respective Si transistors 520, 530 can be formed as Si PMOS or NMOS transistors, or any other suitable type of Si-based transistors. The remaining area of the Si transistor stack is filled with an inter-layer dielectric (ILD) 508.

In addition, vias are formed through the Si transistor stack down to the III-N transistor 510 to couple the source/drain contacts 516 and gate 519 of the III-N transistor 510 to an interconnect (not shown).

In various embodiments, certain layers of integrated circuit 500 may be omitted, added, or rearranged. Moreover, certain layers may be formed using materials other than those described above, including any of the materials described throughout this disclosure. Further, in actual embodiments, integrated circuit 500 may include any number of III-N and/or Si transistors.

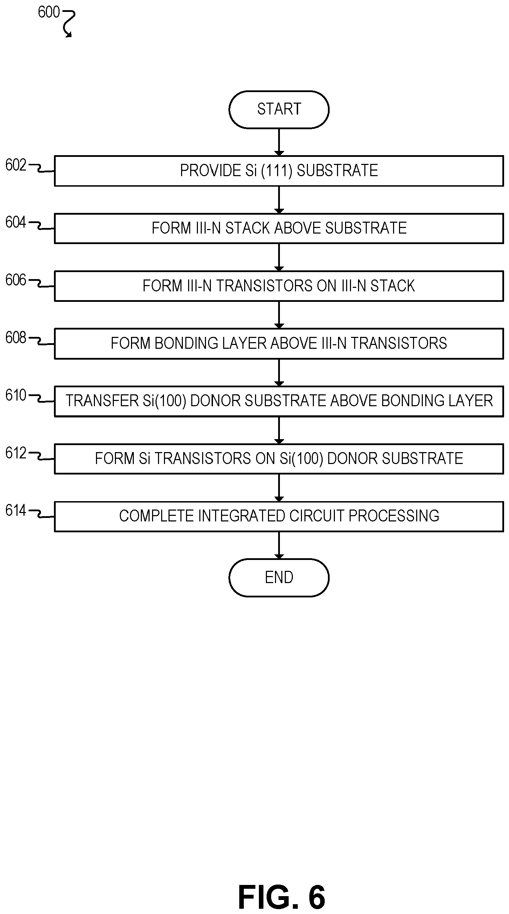

**FIG. 6** illustrates a flowchart 600 for fabricating an integrated circuit with vertically-integrated group III-nitride (III-N) and silicon (Si) transistors on the same die. In some embodiments, for example, flowchart 600 may be used to fabricate the integrated circuit 500 of FIGS. 5A-C. It will be appreciated in light of the present disclosure, however, that flowchart 600 is only one example methodology for arriving at the example integrated circuit structures shown and described throughout this disclosure.

The steps of flowchart 600 may be performed using any suitable semiconductor fabrication techniques. For example, film deposition-such as depositing layers, filling portions of layers (e.g., removed portions), and filling via openings-may be performed using any suitable deposition techniques, including, for example, chemical vapor deposition (CVD), metalorganic chemical vapor deposition (MOCVD), molecular beam epitaxy (MBE) atomic layer deposition (ALD), and/or physical vapor deposition (PVD). Moreover, patterning and removal-such as interconnect patterning, forming via openings, and shaping-may be performed using any suitable techniques, such as lithography-based patterning/masking and/or etching.

The flowchart begins at block 602 by providing a substrate for fabrication of III-N transistors (e.g., GaN NMOS), such as a silicon (Si) (111) substrate.

The flowchart then proceeds to block 604 to form a base stack of layers for the III-N transistor above the substrate. In particular, the base stack may include buffer, channel, and polarization layers, each of which may include one or more of the III-N materials described throughout this disclosure. The base stack may also include an insulator layer, which may include any of the dielectric or insulating materials described through this disclosure.

The flowchart then proceeds to block 606 to form the III-N transistors on the base stack. In particular, the base stack is patterned into the channel, polarization, and insulator layers for the respective III-N transistors. In addition, source/drain regions, source/drain contacts, and a metal T-gate with a gate dielectric are formed for the respective III-N transistors. The source/drain regions for the III-N transistors may include one or more of the III-N materials described throughout this disclosure. The source/drain contacts and/or metal T-gates may include one or more metals and/or other electrically conductive materials described throughout this disclosure.

The flowchart then proceeds to block 608 to form a bonding layer above the III-N transistor stack. In some embodiments, for example, the bonding layer is formed by depositing one or more bonding materials above the finished III-N transistor stack, such as a bonding oxide (e.g., silicon oxide (SiO)), and then smoothing out the surface until pristinely flat (e.g., via polishing/etching).

The flowchart then proceeds to block 610 to transfer a donor substrate for the Si transistors on/above the bonding layer, such as a Si(100) donor substrate. In this manner, the bonding layer enables the Si donor substrate to bond with, or stick to, the underlying III-N transistor stack.

The flowchart then proceeds to block 612 to form the Si transistors on the Si(100) donor substrate. In particular, the Si(100) donor substrate is patterned into the channels for the respective Si transistors. In addition, source/drain regions, source/drain contacts, and a gate stack are formed for the respective Si transistors. The source/drain regions may include one or more of the group IV materials described throughout this disclosure. The source/drain contacts may include one or more metals and/or other electrically conductive materials described throughout this disclosure. The gate stack may include gate spacers, a gate dielectric, a work function metal, and a fill metal, each of which may contain respective materials described throughout this disclosure.

The flowchart then proceeds to block 614 to complete the integrated circuit by performing any remaining backend processing.

At this point, the flowchart may be complete. In some embodiments, however, the flowchart may restart and/or certain blocks may be repeated. For example, in some embodiments, the flowchart may restart at block 602 to continue fabricating integrated III-N and Si transistors on the same die.

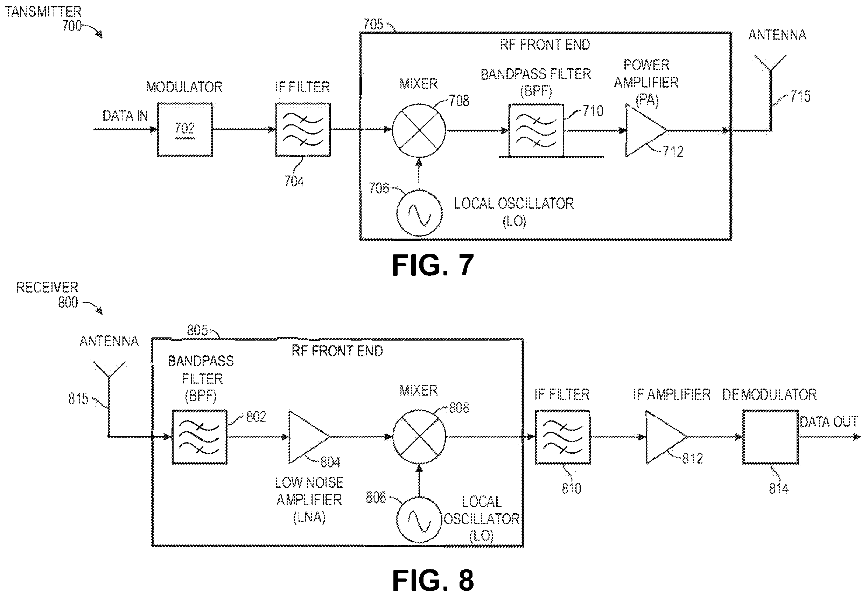

**FIGS. 7-8** illustrate a radio frequency (RF) transmitter 700 and an RF receiver 800 in accordance with certain embodiments. In some embodiments, the transmitter 700 and receiver 800 may be separate components or they may be integrated or combined as a transceiver.

In the illustrated embodiment, the transmitter 700 includes a modulator 702, an intermediate frequency (IF) filter 704, a local oscillator 706, a mixer 708, a bandpass filter 710, a power amplifier 712, and an antenna 715. The local oscillator 706, mixer 708, bandpass filter 710, and power amplifier 712 may be part of the RF front end 705 of the transmitter 700. The components of the transmitter 700 are collectively used to convert an information signal into a carrier signal, which is then transmitted by the antenna 715 as a radio signal (e.g., radio waves).

The radio signal from the transmitter 700 is then received at the receiver 800. In the illustrated embodiment, the receiver 800 includes an antenna 815, a bandpass filter 802, a low noise amplifier 804, a local oscillator 806, a mixer 808, an intermediate frequency (IF) filter 810, an intermediate frequency (IF) amplifier 812, and a demodulator 814. The bandpass filter 802, low noise amplifier 804, local oscillator 806, and mixer 808 may be part of the RF front end 805 of the receiver 800, which is responsible for processing the incoming radio signal at its original radio frequency (RF) before converting the signal to a lower intermediate frequency (IF) for further processing.

For example, when a radio signal is received by the antenna 815, the bandpass filter 802 removes any signal interference at the image frequency and prevents strong out-of-band signals from saturating the input stages. The low noise amplifier 804 is used to amplify weak signals without adding noise. The local oscillator 806 generates a radio frequency signal at an offset from the incoming signal, which is used by the mixer 808. For example, the mixer 808 mixes the incoming signal with the signal from the local oscillator 806 to convert the incoming signal to an intermediate frequency (IF). The remaining processing is then performed on the signal at the intermediate frequency by the other components of the receiver 800, such as the IF filter 810, IF amplifier 812, and demodulator 814.

In some embodiments, the transmitter 700 and/or receiver 800 may be implemented using the integrated III-N and Si transistor embodiments described throughout this disclosure. For example, some or all of the components of the transmitter 700 and/or receiver 800 may be implemented using a combination of III-N and Si transistors integrated on a single die of an integrated circuit, including the RF front end 705, 805 and corresponding control logic.

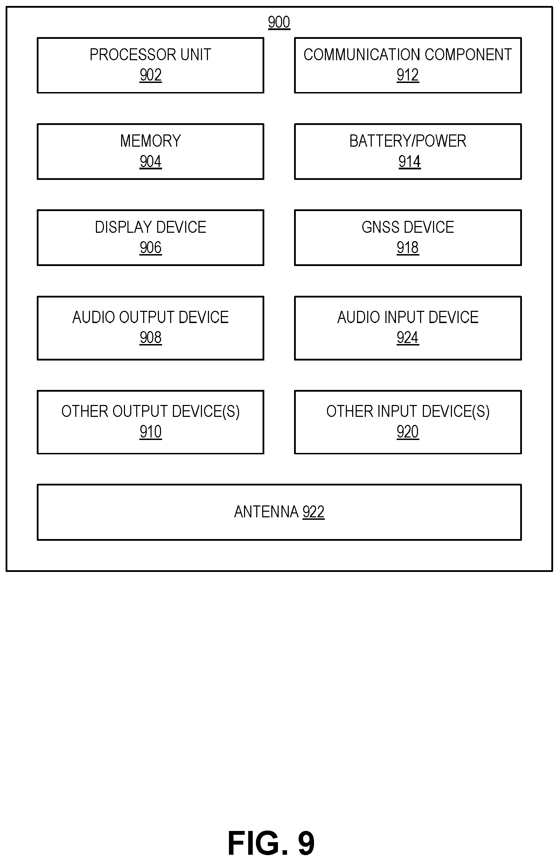

**FIG. 9** illustrates a block diagram of an example electrical device 900 that may include one or more of the embodiments disclosed herein. For example, any suitable ones of the components of the electrical device 900-such as processor units 902, memory 904, communication components 912 (e.g., network interface controllers, RF transceivers/front-end circuits)-may include integrated III-N and Si transistors on a single die as described throughout this disclosure. A number of components are illustrated in FIG. 9 as included in the electrical device 900, but any one or more of these components may be omitted or duplicated, as suitable for the application. In some embodiments, some or all of the components included in the electrical device 900 may be attached to one or more motherboards mainboards, or system boards. In some embodiments, one or more of these components are fabricated onto a single system-on-a-chip (SoC) die.

Additionally, in various embodiments, the electrical device 900 may not include one or more of the components illustrated in FIG. 9, but the electrical device 900 may include interface circuitry for coupling to the one or more components. For example, the electrical device 900 may not include a display device 906, but may include display device interface circuitry (e.g., a connector and driver circuitry) to which a display device 906 may be coupled. In another set of examples, the electrical device 900 may not include an audio input device 924 or an audio output device 908, but may include audio input or output device interface circuitry (e.g., connectors and supporting circuitry) to which an audio input device 924 or audio output device 908 may be coupled.

The electrical device 900 may include one or more processor units 902 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 902 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 900 may include a memory 904, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 904 may include memory that is located on the same integrated circuit die as the processor unit 902. This memory may be used as cache memory (e.g., Level 1 (L1), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 900 can comprise one or more processor units 902 that are heterogeneous or asymmetric to another processor unit 902 in the electrical device 900. There can be a variety of differences between the processing units 902 in a system in terms of a spectrum of metrics of merit including architectural, microarchitectural, thermal, power consumption characteristics, and the like. These differences can effectively manifest themselves as asymmetry and heterogeneity among the processor units 902 in the electrical device 900.

In some embodiments, the electrical device 900 may include a communication component 912 (e.g., one or more communication components). For example, the communication component 912 can manage wireless communications for the transfer of data to and from the electrical device 900. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 912 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 912 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 912 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 912 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 912 may operate in accordance with other wireless protocols in other embodiments. In some embodiments, the communication component 912 may include a radio-frequency (RF) front-end circuit. The electrical device 900 may include an antenna 922 to facilitate wireless communications and/or to receive other wireless communications (such as AM or FM radio transmissions).

In some embodiments, the communication component 912 may manage wired communications, such as electrical, optical, or any other suitable communication protocols (e.g., IEEE 802.3 Ethernet standards). As noted above, the communication component 912 may include multiple communication components. For instance, a first communication component 912 may be dedicated to shorter-range wireless communications such as Wi-Fi or Bluetooth, and a second communication component 912 may be dedicated to longer-range wireless communications such as global positioning system (GPS), EDGE, GPRS, CDMA, WiMAX, LTE, EV-DO, or others. In some embodiments, a first communication component 912 may be dedicated to wireless communications, and a second communication component 912 may be dedicated to wired communications. In some embodiments, the communication component 912 may include a network interface controller.

The electrical device 900 may include battery/power circuitry 914. The battery/power circuitry 914 may include one or more energy storage devices (e.g., batteries or capacitors) and/or circuitry for coupling components of the electrical device 900 to an energy source separate from the electrical device 900 (e.g., AC line power).

The electrical device 900 may include a display device 906 (or corresponding interface circuitry, as discussed above). The display device 906 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 900 may include an audio output device 908 (or corresponding interface circuitry, as discussed above). The audio output device 908 may include any embedded or wired or wirelessly connected external device that generates an audible indicator, such speakers, headsets, or earbuds.

The electrical device 900 may include an audio input device 924 (or corresponding interface circuitry, as discussed above). The audio input device 924 may include any embedded or wired or wirelessly connected device that generates a signal representative of a sound, such as microphones, microphone arrays, or digital instruments (e.g., instruments having a musical instrument digital interface (MIDI) output). The electrical device 900 may include a Global Navigation Satellite System (GNSS) device 918 (or corresponding interface circuitry, as discussed above), such as a Global Positioning System (GPS) device. The GNSS device 918 may be in communication with a satellite-based system and may determine a geolocation of the electrical device 900 based on information received from one or more GNSS satellites, as known in the art.

The electrical device 900 may include other output device(s) 910 (or corresponding interface circuitry, as discussed above). Examples of the other output device(s) 910 may include an audio codec, a video codec, a printer, a wired or wireless transmitter for providing information to other devices, or an additional storage device.

The electrical device 900 may include other input device(s) 920 (or corresponding interface circuitry, as discussed above). Examples of the other input device(s) 920 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 900 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 900 may be any other electronic device that processes data. In some embodiments, the electrical device 900 may comprise multiple discrete physical components. Given the range of devices that the electrical device 900 can be manifested as in various embodiments, in some embodiments, the electrical device 900 can be referred to as a computing device or a computing system.

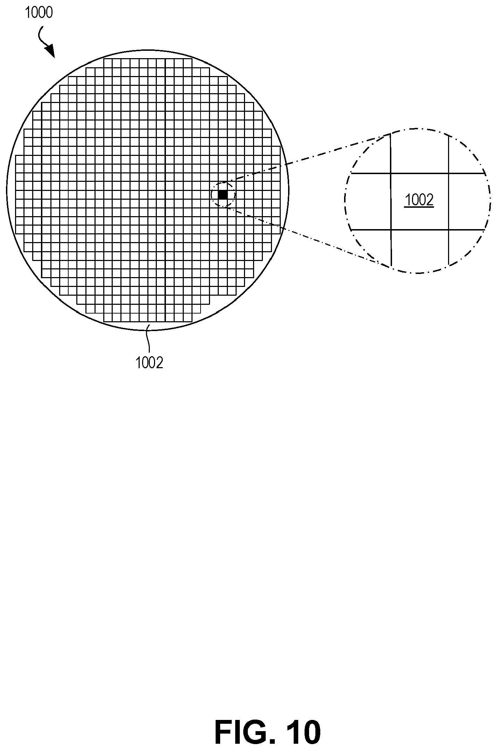

**FIG. 10** is a top view of a wafer 1000 and dies 1002 that may be included in any of the embodiments disclosed herein. The wafer 1000 may be composed of semiconductor material and may include one or more dies 1002 having integrated circuit structures formed on a surface of the wafer 1000. The individual dies 1002 may be a repeating unit of an integrated circuit product that includes any suitable integrated circuit. After the fabrication of the semiconductor product is complete, the wafer 1000 may undergo a singulation process in which the dies 1002 are separated from one another to provide discrete "chips" of the integrated circuit product. The die 1002 may be any of the dies disclosed herein. The die 1002 may include horizontally- and/or vertically-integrated III-N and Si transistors as described throughout this disclosure, supporting circuitry to route electrical signals to the transistors, passive components (e.g., signal traces, resistors, capacitors, or inductors), and/or any other integrated circuit components. In some embodiments, the wafer 1000 or the die 1002 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1002. For example, a memory array formed by multiple memory devices may be formed on a same die 1002 as a processor unit (e.g., the processor unit 902 of FIG. 9) or other logic that is configured to store information in the memory devices or execute instructions stored in the memory array. Various ones of the microelectronic assemblies disclosed herein may be manufactured using a die-to-wafer assembly technique in which some dies are attached to a wafer 1000 that include others of the dies, and the wafer 1000 is subsequently singulated.

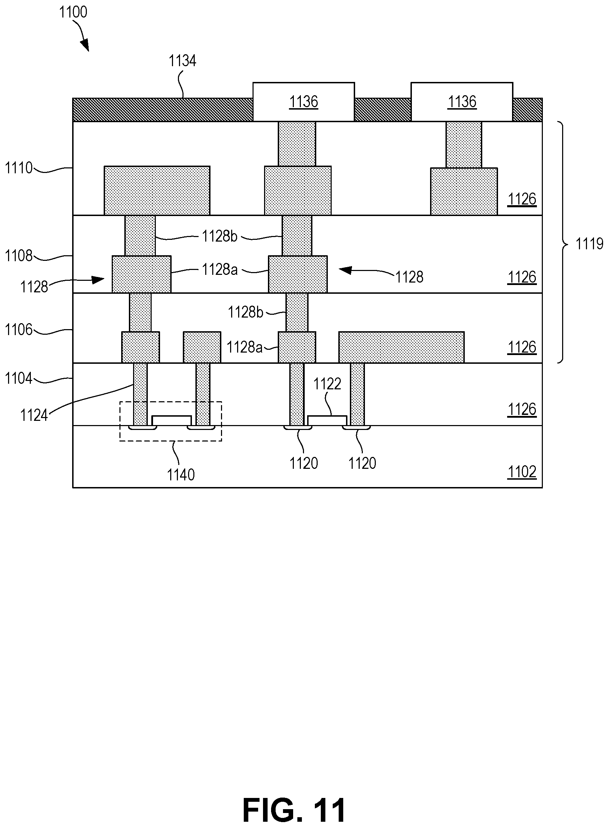

**FIG. 11** is a cross-sectional side view of an integrated circuit device 1100 that may be included in any of the embodiments disclosed herein (e.g., in any of the dies). One or more of the integrated circuit devices 1100 may be included in one or more dies 1002 (FIG. 10). The integrated circuit device 1100 may be formed on a die substrate 1102 (e.g., the wafer 1000 of FIG. 10) and may be included in a die (e.g., the die 1002 of FIG. 10). The die substrate 1102 may be a semiconductor substrate composed of semiconductor material systems including, for example, n-type or p-type materials systems (or a combination of both). The die substrate 1102 may include, for example, a crystalline substrate formed using a bulk silicon or a silicon-on-insulator (SOI) substructure. In some embodiments, the die substrate 1102 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 1102. Although a few examples of materials from which the die substrate 1102 may be formed are described here, any material that may serve as a foundation for an integrated circuit device 1100 may be used. The die substrate 1102 may be part of a singulated die (e.g., the dies 1002 of FIG. 10) or a wafer (e.g., the wafer 1000 of FIG. 10).

The integrated circuit device 1100 may include one or more device layers 1104 disposed on the die substrate 1102. The device layer 1104 may include features of one or more transistors 1140 (e.g., metal oxide semiconductor field-effect transistors (MOSFETs)) formed on the die substrate 1102. The transistors 1140 may include, for example, one or more source and/or drain (S/D) regions 1120, a gate 1122 to control current flow between the S/D regions 1120, and one or more S/D contacts 1124 to route electrical signals to/from the S/D regions 1120. The transistors 1140 may include additional features not depicted for the sake of clarity, such as device isolation regions, gate contacts, and the like. The transistors 1140 are not limited to the type and configuration depicted in FIG. 11 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon, nanosheet, or nanowire transistors.

Returning to FIG. 11, a transistor 1140 may include a gate 1122 formed of at least two layers, a gate dielectric and a gate electrode. The gate dielectric may include one layer or a stack of layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 1140 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1140 along the source-channel-drain direction, the gate electrode may consist of a U-shaped structure that includes a bottom portion substantially parallel to the surface of the die substrate 1102 and two sidewall portions that are substantially perpendicular to the top surface of the die substrate 1102. In other embodiments, at least one of the metal layers that form the gate electrode may simply be a planar layer that is substantially parallel to the top surface of the die substrate 1102 and does not include sidewall portions substantially perpendicular to the top surface of the die substrate 1102. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1120 may be formed within the die substrate 1102 adjacent to the gate 1122 of individual transistors 1140. The S/D regions 1120 may be formed using an implantation/diffusion process or an etching/deposition process, for example. In the former process, dopants such as boron, aluminum, antimony, phosphorous, or arsenic may be ion-implanted into the die substrate 1102 to form the S/D regions 1120. An annealing process that activates the dopants and causes them to diffuse farther into the die substrate 1102 may follow the ion-implantation process. In the latter process, the die substrate 1102 may first be etched to form recesses at the locations of the S/D regions 1120. An epitaxial deposition process may then be carried out to fill the recesses with material that is used to fabricate the S/D regions 1120. In some implementations, the S/D regions 1120 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1120 may be formed using one or more alternate semiconductor materials such as germanium or a group III-V material or alloy. In further embodiments, one or more layers of metal and/or metal alloys may be used to form the S/D regions 1120.

Electrical signals, such as power and/or input/output (I/O) signals, may be routed to and/or from the devices (e.g., transistors 1140) of the device layer 1104 through one or more interconnect layers disposed on the device layer 1104 (illustrated in FIG. 11 as interconnect layers 1106-1110). For example, electrically conductive features of the device layer 1104 (e.g., the gate 1122 and the S/D contacts 1124) may be electrically coupled with the interconnect structures 1128 of the interconnect layers 1106-1110. The one or more interconnect layers 1106-1110 may form a metallization stack (also referred to as an "ILD stack") 1119 of the integrated circuit device 1100.

The interconnect structures 1128 may be arranged within the interconnect layers 1106-1110 to route electrical signals according to a wide variety of designs; in particular, the arrangement is not limited to the particular configuration of interconnect structures 1128 depicted in FIG. 11. Although a particular number of interconnect layers 1106-1110 is depicted in FIG. 11, embodiments of the present disclosure include integrated circuit devices having more or fewer interconnect layers than depicted.

In some embodiments, the interconnect structures 1128 may include lines 1128a and/or vias 1128b filled with an electrically conductive material such as a metal. The lines 1128a may be arranged to route electrical signals in a direction of a plane that is substantially parallel with a surface of the die substrate 1102 upon which the device layer 1104 is formed. For example, the lines 1128a may route electrical signals in a direction in and out of the page and/or in a direction across the page from the perspective of FIG. 11. The vias 1128b may be arranged to route electrical signals in a direction of a plane that is substantially perpendicular to the surface of the die substrate 1102 upon which the device layer 1104 is formed. In some embodiments, the vias 1128b may electrically couple lines 1128a of different interconnect layers 1106-1110 together.

The interconnect layers 1106-1110 may include a dielectric material 1126 disposed between the interconnect structures 1128, as shown in FIG. 11. In some embodiments, dielectric material 1126 disposed between the interconnect structures 1128 in different ones of the interconnect layers 1106-1110 may have different compositions; in other embodiments, the composition of the dielectric material 1126 between different interconnect layers 1106-1110 may be the same. The device layer 1104 may include a dielectric material 1126 disposed between the transistors 1140 and a bottom layer of the metallization stack as well. The dielectric material 1126 included in the device layer 1104 may have a different composition than the dielectric material 1126 included in the interconnect layers 1106-1110; in other embodiments, the composition of the dielectric material 1126 in the device layer 1104 may be the same as a dielectric material 1126 included in any one of the interconnect layers 1106-1110.

A first interconnect layer 1106 (referred to as Metal 1 or "M1") may be formed directly on the device layer 1104. In some embodiments, the first interconnect layer 1106 may include lines 1128a and/or vias 1128b, as shown. The lines 1128a of the first interconnect layer 1106 may be coupled with contacts (e.g., the S/D contacts 1124) of the device layer 1104. The vias 1128b of the first interconnect layer 1106 may be coupled with the lines 1128a of a second interconnect layer 1108.

The second interconnect layer 1108 (referred to as Metal 2 or "M2") may be formed directly on the first interconnect layer 1106. In some embodiments, the second interconnect layer 1108 may include via 1128b to couple the lines 1128 of the second interconnect layer 1108 with the lines 1128a of a third interconnect layer 1110. Although the lines 1128a and the vias 1128b are structurally delineated with a line within individual interconnect layers for the sake of clarity, the lines 1128a and the vias 1128b may be structurally and/or materially contiguous (e.g., simultaneously filled during a dual-damascene process) in some embodiments.

The third interconnect layer 1110 (referred to as Metal 3 or "M3") (and additional interconnect layers, as desired) may be formed in succession on the second interconnect layer 1108 according to similar techniques and configurations described in connection with the second interconnect layer 1108 or the first interconnect layer 1106. In some embodiments, the interconnect layers that are "higher up" in the metallization stack 1119 in the integrated circuit device 1100 (i.e., farther away from the device layer 1104) may be thicker that the interconnect layers that are lower in the metallization stack 1119, with lines 1128a and vias 1128b in the higher interconnect layers being thicker than those in the lower interconnect layers.

The integrated circuit device 1100 may include a solder resist material 1134 (e.g., polyimide or similar material) and one or more conductive contacts 1136 formed on the interconnect layers 1106-1110. In FIG. 11, the conductive contacts 1136 are illustrated as taking the form of bond pads. The conductive contacts 1136 may be electrically coupled with the interconnect structures 1128 and configured to route the electrical signals of the transistor(s) 1140 to external devices. For example, solder bonds may be formed on the one or more conductive contacts 1136 to mechanically and/or electrically couple an integrated circuit die including the integrated circuit device 1100 with another component (e.g., a printed circuit board). The integrated circuit device 1100 may include additional or alternate structures to route the electrical signals from the interconnect layers 1106-1110; for example, the conductive contacts 1136 may include other analogous features (e.g., posts) that route the electrical signals to external components. The conductive contacts 1136 may serve as any of the conductive contacts described throughout this disclosure.

In some embodiments in which the integrated circuit device 1100 is a double-sided die, the integrated circuit device 1100 may include another metallization stack (not shown) on the opposite side of the device layer(s) 1104. This metallization stack may include multiple interconnect layers as discussed above with reference to the interconnect layers 1106-1110, to provide conductive pathways (e.g., including conductive lines and vias) between the device layer(s) 1104 and additional conductive contacts (not shown) on the opposite side of the integrated circuit device 1100 from the conductive contacts 1136. These additional conductive contacts may serve as any of the conductive contacts described throughout this disclosure.

In other embodiments in which the integrated circuit device 1100 is a double-sided die, the integrated circuit device 1100 may include one or more through silicon vias (TSVs) through the die substrate 1102; these TSVs may make contact with the device layer(s) 1104, and may provide conductive pathways between the device layer(s) 1104 and additional conductive contacts (not shown) on the opposite side of the integrated circuit device 1100 from the conductive contacts 1136. These additional conductive contacts may serve as any of the conductive contacts described throughout this disclosure. In some embodiments, TSVs extending through the substrate can be used for routing power and ground signals from conductive contacts on the opposite side of the integrated circuit device 1100 from the conductive contacts 1136 to the transistors 1140 and any other components integrated into the die 1100, and the metallization stack 1119 can be used to route I/O signals from the conductive contacts 1136 to transistors 1140 and any other components integrated into the die 1100.

Multiple integrated circuit devices 1100 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

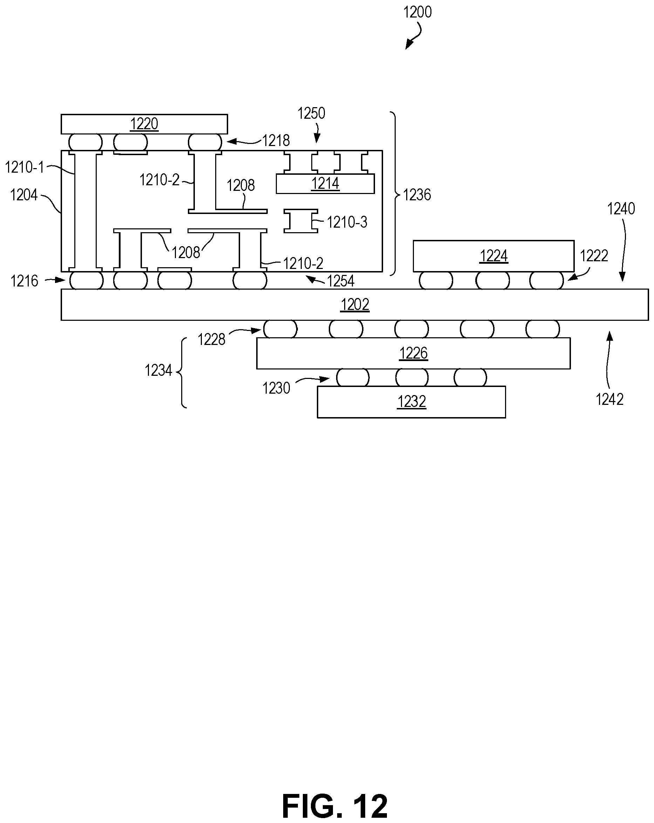

**FIG. 12** is a cross-sectional side view of an integrated circuit device assembly 1200 that may include any of the embodiments disclosed herein. In some embodiments, the integrated circuit device assembly 1200 may be a microelectronic assembly. The integrated circuit device assembly 1200 includes a number of components disposed on a circuit board 1202 (which may be a motherboard, system board, mainboard, etc.). The integrated circuit device assembly 1200 includes components disposed on a first face 1240 of the circuit board 1202 and an opposing second face 1242 of the circuit board 1202; generally, components may be disposed on one or both faces 1240 and 1242. Any of the integrated circuit components discussed below with reference to the integrated circuit device assembly 1200 may take the form of any suitable ones of the embodiments of the microelectronic assemblies 100 disclosed herein.

In some embodiments, the circuit board 1202 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 1202. In other embodiments, the circuit board 1202 may be a non-PCB substrate. The integrated circuit device assembly 1200 illustrated in FIG. 12 includes a package-on-interposer structure 1236 coupled to the first face 1240 of the circuit board 1202 by coupling components 1216. The coupling components 1216 may electrically and mechanically couple the package-on-interposer structure 1236 to the circuit board 1202, and may include solder balls (as shown in FIG. 12), pins (e.g., as part of a pin grid array (PGA), contacts (e.g., as part of a land grid array (LGA)), male and female portions of a socket, an adhesive, an underfill material, and/or any other suitable electrical and/or mechanical coupling structure. The coupling components 1216 may serve as the coupling components illustrated or described for any of the substrate assembly or substrate assembly components described herein, as appropriate.

The package-on-interposer structure 1236 may include an integrated circuit component 1220 coupled to an interposer 1204 by coupling components 1218. The coupling components 1218 may take any suitable form for the application, such as the forms discussed above with reference to the coupling components 1216. Although a single integrated circuit component 1220 is shown in FIG. 12, multiple integrated circuit components may be coupled to the interposer 1204; indeed, additional interposers may be coupled to the interposer 1204. The interposer 1204 may provide an intervening substrate used to bridge the circuit board 1202 and the integrated circuit component 1220.

The integrated circuit component 1220 may be a packaged or unpacked integrated circuit product that includes one or more integrated circuit dies (e.g., the die 1002 of FIG. 10, the integrated circuit device 1100 of FIG. 11) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 1220, a single monolithic integrated circuit die comprises solder bumps attached to contacts on the die. The solder bumps allow the die to be directly attached to the interposer 1204. The integrated circuit component 1220 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 1220 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 1220 comprises multiple integrated circuit dies, they dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 1220 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 1204 may spread connections to a wider pitch or reroute a connection to a different connection. For example, the interposer 1204 may couple the integrated circuit component 1220 to a set of ball grid array (BGA) conductive contacts of the coupling components 1216 for coupling to the circuit board 1202. In the embodiment illustrated in FIG. 12, the integrated circuit component 1220 and the circuit board 1202 are attached to opposing sides of the interposer 1204; in other embodiments, the integrated circuit component 1220 and the circuit board 1202 may be attached to a same side of the interposer 1204. In some embodiments, three or more components may be interconnected by way of the interposer 1204.

In some embodiments, the interposer 1204 may be formed as a PCB, including multiple metal layers separated from one another by layers of dielectric material and interconnected by electrically conductive vias. In some embodiments, the interposer 1204 may be formed of an epoxy resin, a fiberglass-reinforced epoxy resin, an epoxy resin with inorganic fillers, a ceramic material, or a polymer material such as polyimide. In some embodiments, the interposer 1204 may be formed of alternate rigid or flexible materials that may include the same materials described above for use in a semiconductor substrate, such as silicon, germanium, and other group III-V and group IV materials. The interposer 1204 may include metal interconnects 1208 and vias 1210, including but not limited to through hole vias 1210-1 (that extend from a first face 1250 of the interposer 1204 to a second face 1254 of the interposer 1204), blind vias 1210-2 (that extend from the first or second faces 1250 or 1254 of the interposer 1204 to an internal metal layer), and buried vias 1210-3 (that connect internal metal layers).

In some embodiments, the interposer 1204 can comprise a silicon interposer. Through silicon vias (TSV) extending through the silicon interposer can connect connections on a first face of a silicon interposer to an opposing second face of the silicon interposer. In some embodiments, an interposer 1204 comprising a silicon interposer can further comprise one or more routing layers to route connections on a first face of the interposer 1204 to an opposing second face of the interposer 1204.

The interposer 1204 may further include embedded devices 1214, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1204. The package-on-interposer structure 1236 may take the form of any of the package-on-interposer structures known in the art. In embodiments where the interposer is a non-printed circuit board

The integrated circuit device assembly 1200 may include an integrated circuit component 1224 coupled to the first face 1240 of the circuit board 1202 by coupling components 1222. The coupling components 1222 may take the form of any of the embodiments discussed above with reference to the coupling components 1216, and the integrated circuit component 1224 may take the form of any of the embodiments discussed above with reference to the integrated circuit component 1220.

The integrated circuit device assembly 1200 illustrated in FIG. 12 includes a package-on-package structure 1234 coupled to the second face 1242 of the circuit board 1202 by coupling components 1228. The package-on-package structure 1234 may include an integrated circuit component 1226 and an integrated circuit component 1232 coupled together by coupling components 1230 such that the integrated circuit component 1226 is disposed between the circuit board 1202 and the integrated circuit component 1232. The coupling components 1228 and 1230 may take the form of any of the embodiments of the coupling components 1216 discussed above, and the integrated circuit components 1226 and 1232 may take the form of any of the embodiments of the integrated circuit component 1220 discussed above. The package-on-package structure 1234 may be configured in accordance with any of the package-on-package structures known in the art.

### Example Embodiments

Illustrative examples of the technologies described throughout this disclosure are provided below. Embodiments of these technologies may include any one or more, and any combination of, the examples described below. In some embodiments, at least one of the systems or components set forth in one or more of the preceding figures may be configured to perform one or more operations, techniques, processes, and/or methods as set forth in the following examples.

Example 1 includes an integrated circuit, comprising: a substrate comprising silicon; a first layer above the substrate, wherein the first layer comprises gallium and nitrogen; a first transistor on the first layer, wherein the first transistor comprises a first source region, a first drain region, a first channel region between the first source region and the first drain region, and a first gate structure above the first channel region, wherein the first channel region comprises at least a portion of the first layer; a bonding layer above the first layer, wherein the bonding layer comprises oxygen; a second layer above the bonding layer, wherein the second layer comprises silicon; and a second transistor on the second layer, wherein the second transistor comprises a second source region, a second drain region, a second channel region between the second source region and the second drain region, and a second gate structure above the second channel region, wherein the second channel region comprises at least a portion of the second layer.

Example 2 includes the integrated circuit of Example 1, wherein the second transistor is lateral to the first transistor.

Example 3 includes the integrated circuit of any of Examples 1-2, wherein the second channel region is perpendicular to the first channel region.

Example 4 includes the integrated circuit of any of Examples 1-3, wherein the second channel region and the first gate structure are coplanar.

Example 5 includes the integrated circuit of Example 1, wherein the second transistor is above the first transistor.

Example 6 includes the integrated circuit of any of Examples 1-5, wherein the bonding layer further comprises silicon.

Example 7 includes the integrated circuit of any of Examples 1-6, further comprising: a polarization layer above the first layer and below the bonding layer, wherein the polarization layer comprises aluminum and nitrogen, and wherein the first gate structure extends into the polarization layer.

Example 8 includes the integrated circuit of Example 7, wherein the polarization layer further comprises gallium or indium.

Example 9 includes the integrated circuit of any of Examples 1-8, wherein the first gate structure is a T-gate comprising an upper portion and a lower portion, wherein the upper portion is wider than the lower portion.

Example 10 includes the integrated circuit of any of Examples 1-9, wherein: the first gate structure comprises a first metal; and the second gate structure comprises a second metal.

Example 11 includes the integrated circuit of Example 10, wherein: the first metal comprises titanium or nickel; and the second metal comprises tungsten.

Example 12 includes the integrated circuit of any of Examples 1-11, wherein: the first source region and the first drain region comprise indium, gallium, and nitrogen; and the second source region and the second drain region comprise silicon.

Example 13 includes the integrated circuit of any of Examples 1-12, wherein: the first transistor is an n-type metal-oxide-semiconductor (NMOS) transistor; and the second transistor is a p-type metal-oxide-semiconductor (PMOS) transistor.

Example 14 includes a computing device, comprising: processing circuitry; memory circuitry; or radio frequency (RF) transceiver circuitry; wherein the processing circuitry, the memory circuitry, or the RF transceiver circuitry comprises an integrated circuit, wherein the integrated circuit comprises: a substrate comprising silicon; a first layer above the substrate, wherein the first layer comprises gallium and nitrogen; a first plurality of transistors on the first layer, wherein individual transistors of the first plurality of transistors comprise a first source region, a first drain region, a first channel region between the first source region and the first drain region, and a first gate structure above the first channel region, wherein the first channel region comprises at least a portion of the first layer; a bonding layer above the first layer, wherein the bonding layer comprises oxygen; a second layer above the bonding layer, wherein the second layer comprises silicon; and a second plurality of transistors on the second layer, wherein individual transistors of the second plurality of transistors comprise a second source region, a second drain region, a second channel region between the second source region and the second drain region, and a second gate structure above the second channel region, wherein the second channel region comprises at least a portion of the second layer.

Example 15 includes the computing device of Example 14, wherein: the RF transceiver circuitry comprises the integrated circuit; and the integrated circuit comprises RF front-end circuitry and RF control circuitry.

Example 16 includes the computing device of any of Examples 14-15, wherein the second plurality of transistors are lateral to the first plurality of transistors.

Example 17 includes the computing device of any of Examples 14-16, wherein the second channel region is perpendicular to the first channel region.

Example 18 includes the computing device of any of Examples 14-15, wherein the second plurality of transistors are above the first plurality of transistors.

Example 19 includes the computing device of any of Examples 14-18, wherein the first gate structure is a T-gate comprising an upper portion and a lower portion, wherein the upper portion is wider than the lower portion.

Example 20 includes the computing device of any of Examples 14-19, wherein: the bonding layer further comprises silicon; the first source region and the first drain region comprise indium, gallium, and nitrogen; the second source region and the second drain region comprise silicon; the first gate structure comprises a first metal; and the second gate structure comprises a second metal.

Example 21 includes the computing device of any of Examples 14-20, wherein: the first plurality of transistors are n-type metal-oxide-semiconductor (NMOS) transistors; and the second plurality of transistors are p-type metal-oxide-semiconductor (PMOS) transistors.

Example 22 includes a method of forming an integrated circuit, comprising: forming a first layer above a substrate, wherein the substrate comprises silicon, and wherein the first layer comprises gallium and nitrogen; patterning a first channel region in the first layer; forming a first source region and a first drain region on opposite sides of the first channel region, wherein the first source region and the first drain region comprise indium, gallium, and nitrogen; forming a bonding layer above the first layer, wherein the bonding layer comprises oxygen; transferring a second layer above the bonding layer, wherein the second layer comprises silicon; patterning a temporary gate structure and a second channel region in the second layer, wherein the temporary gate structure is above the first channel region, and wherein the second channel region is lateral to the temporary gate structure; forming a second source region and a second drain region on opposite sides of the second channel region, wherein the second source region and the second drain region comprise silicon; forming a first gate structure above the first channel region, wherein the first gate structure is formed by replacing the temporary gate structure with a first metal; and forming a second gate structure above the second channel region, wherein the second gate structure comprises a second metal.

Example 23 includes the method of Example 22, further comprising: forming a polarization layer above the first layer and below the bonding layer, wherein the polarization layer comprises aluminum and nitrogen.

Example 24 includes the method of any of Examples 22-23, wherein the second channel region is perpendicular to the first channel region.

Example 25 includes the method of any of Examples 22-24, wherein the first gate structure is a T-gate comprising an upper portion and a lower portion, wherein the upper portion is wider than the lower portion.

Example 26 includes any of the preceding examples, wherein: the substrate has a 111 crystal lattice orientation; and the second layer has a 100 crystal lattice orientation.

In the foregoing description, various aspects of the illustrative implementations are described using terms commonly employed by those skilled in the art to convey the substance of their work to others skilled in the art. However, it will be apparent to those skilled in the art that the present disclosure may be practiced with only some of the described aspects. For purposes of explanation, specific numbers, materials and configurations are set forth in order to provide a thorough understanding of the illustrative implementations. However, it will be apparent to one skilled in the art that the present disclosure may be practiced without the specific details. In other instances, well-known features are omitted or simplified in order not to obscure the illustrative implementations.

Various operations will be described as multiple discrete operations, in turn, in a manner that is most helpful in understanding the present disclosure. However, the order of description should not be construed to imply that these operations are necessarily order dependent. In particular, these operations may not be performed in the order of presentation.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C).

The terms "over," "under," "between," "above," and "on" as used herein may refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening features.

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact.

In various embodiments, the phrase "a first feature formed, deposited, or otherwise disposed on a second feature" may mean that the first feature is formed, deposited, or disposed over the second feature, and at least a part of the first feature may be in direct contact (e.g., direct physical and/or electrical contact) or indirect contact (e.g., having one or more other features between the first feature and the second feature) with at least a part of the second feature.

Where the disclosure recites "a" or "a first" element or the equivalent thereof, such disclosure includes one or more such elements, neither requiring nor excluding two or more such elements. Further, ordinal indicators (e.g., first, second, or third) for identified elements are used to distinguish between the elements, and do not indicate or imply a required or limited number of such elements, nor do they indicate a particular position or order of such elements unless otherwise specifically stated.

As used herein, the term "circuitry" may refer to, be part of, or include an Application Specific Integrated Circuit (ASIC), an electronic circuit, a processor (shared, dedicated, or group), and/or memory (shared, dedicated, or group) that execute one or more software or firmware programs, a combinational logic circuit, and/or other suitable hardware components that provide the described functionality. As used herein, "computer-implemented method" may refer to any method executed by one or more processors, a computer system having one or more processors, a mobile device such as a smartphone (which may include one or more processors), a tablet, a laptop computer, a set-top box, a gaming console, and so forth.

## Claims

1. An integrated circuit device, comprising:
a substrate comprising silicon;
a first layer above the substrate, wherein the first layer comprises gallium and nitrogen;
a first transistor on the first layer, wherein the first transistor comprises a first source region, a first drain region, a first channel region between the first source region and the first drain region, and a first gate structure above the first channel region, wherein the first channel region comprises at least a portion of the first layer;
a bonding layer above the first layer, wherein the bonding layer comprises oxygen;
a second layer above the bonding layer, wherein the second layer comprises silicon; and
a second transistor on the second layer, wherein the second transistor comprises a second source region, a second drain region, a second channel region between the second source region and the second drain region, and a second gate structure above the second channel region, wherein the second channel region comprises at least a portion of the second layer.

2. The integrated circuit device of Claim 1, wherein the second transistor is lateral to the first transistor.

3. The integrated circuit device of any of Claims 1-2, wherein the second channel region is perpendicular to the first channel region.

4. The integrated circuit device of any of Claims 1-3, wherein the second channel region and the first gate structure are coplanar.

5. The integrated circuit device of Claim 1, wherein the second transistor is above the first transistor.

6. The integrated circuit device of any of Claims 1-5, further comprising:
a polarization layer above the first layer and below the bonding layer, wherein the polarization layer comprises aluminum and nitrogen, and wherein the first gate structure extends into the polarization layer.

7. The integrated circuit device of Claim 6, wherein the polarization layer further comprises gallium or indium.

8. The integrated circuit device of any of Claims 1-7, wherein the first gate structure is a T-gate comprising an upper portion and a lower portion, wherein the upper portion is wider than the lower portion.

9. The integrated circuit device of any of Claims 1-8, wherein:
the first gate structure comprises a first metal; and
the second gate structure comprises a second metal.

10. The integrated circuit device of Claim 9, wherein:
the first metal comprises tungsten or titanium; and
the second metal comprises tungsten or titanium.

11. The integrated circuit device of any of Claims 1-10, wherein:
the first source region and the first drain region comprise indium, gallium, and nitrogen;
the second source region and the second drain region comprise silicon; and
the bonding layer further comprises silicon.

12. The integrated circuit device of any of Claims 1-11, wherein:
the first transistor is an n-type metal-oxide-semiconductor (NMOS) transistor; and
the second transistor is a p-type metal-oxide-semiconductor (PMOS) transistor.

13. The integrated circuit device of any of Claims 1-12, further comprising:
processing circuitry;
memory circuitry; or
radio frequency (RF) transceiver circuitry;
wherein the processing circuitry, the memory circuitry, or the RF transceiver circuitry comprises an integrated circuit die, wherein the integrated circuit die comprises the substrate, the first layer, the first transistor, the bonding layer, the second layer, and the second transistor.

14. A method of forming the integrated circuit device as claimed in any preceding claim.

15. At least one machine-accessible storage medium having instructions stored thereon, wherein the instructions, when executed on a machine, cause the machine to perform a method or realize an apparatus as claimed in any preceding claim.
